# EUROPEAN PATENT SPECIFICATION

(11) **EP 3 513 432 B1**
(45) Date of publication and mention of the grant of the patent: **07.04.2021**
(21) Application number: 17777186.2
(22) Date of filing: 13.09.2017
(51) Int. Cl.: H01L 25/18, H01L 25/07, H01L 23/00, H01L 23/40, H01L 25/11, H01L 23/46, H01L 25/16

(54) **PRESS-PACK POWER MODULE**
PRESSPACKLEISTUNGSMODUL
MODULE DE PUISSANCE TYPE PAQUET PRESSÉ

(30) Priority: 15.09.2016 EP 16188969
(43) Date of publication of application: 24.07.2019
(73) Proprietor: RISE Research Institutes of Sweden AB, 501 15 Borås (SE)
(72) Inventor: NEE, Hans-Peter, 197 34 Bro (SE); HAMMAM, Tag, 174 47 Sundbyberg (SE); KOSTOV, Konstantin, 162 57 Vällingby (SE)
(74) Representative: AWA Sweden AB
(86) International application number: PCT/EP2017/073051
(87) International publication number: WO 2018/050713

(56) References cited:
- US-A- 4 748 495
- US-A- 5 164 624

## Description

### TECHNICAL FIELD OF THE INVENTION

The present invention relates to a power electronic module, and more specifically the present invention relates to a power module with clamped semiconductor chips.

### BACKGROUND

A power module may be described as a device that includes a plurality of semiconductor chips which has proven to be an indispensible device for many power electronic switching applications. The semiconductor chips often include power electronic components that can turn large currents on and off at high voltage levels with very low losses, e.g. thyristors, IGBTs (insulatedgate bipolar transistors), MOSFETs (metal-oxide-semiconductor field-effect transistors), BJTs (bipolar junction transistors). Power modules are used in a wide range of applications within the field of power electronics, such as highvoltage DC (HVDC), electric vehicles, interfacing renewable energy sources, and others.

The first power semiconductor module was introduced in the 1970s, where two chips (thyristor and/or rectifier) were combined by soldering them together with electrical contacts on metalized ceramic substrates and by putting them in a common plastic housing. These first power modules provided enormous system advantages, such as mounting many devices on one common heat sink and connecting them electrically by means of a bus bar. Before this, discrete devices had to be clamped or screwed to individual coolers which had to be isolated from each other. Hence, power electronics systems became more compact, cost effective and reliable. These requirements for reduced cost, size and weight, as well as increased reliability, have not decreased over the recent decades.

The semiconductor chips in most contemporary power modules are soldered or sintered on a metalized ceramic substrate (most often DBC), with wire bonding on the opposite side of the chips. However, soldering/sintering and wire bonding limits the reliability of the power modules due to the high stresses caused by thermal mismatch and thermal gradients at the solder/sinter joints. In order to overcome the disadvantages of the soldering/sintering the so-called free-floating press-pack power modules were introduced in the 1990's. There are two types of press-pack power modules: one where the chips are clamped between two common pole pieces/contact pistons, as disclosed in US 7,538,436, and the second basic technology has chips contacted by individual springs, where the clamping force is determined by springs, as e.g. disclosed in US 9,903,426.

US 5 164 624 A discloses a semiconductor power module comprising a first clamping structure comprising two clamping bodies and a second clamping structure comprising two heat sinks.

A unique benefit of the press-pack design is that the maximum tensile stress in the semiconductor die, caused by the coefficient of thermal expansion (CTE) mismatch, is limited by the friction in the interface between the semiconductor die and the metallic electrical current collectors (commonly known as free-floating press-pack). Therefore, an important design aspect with the press-pack technology is the conflict between the desired high compressive pressure in order to maximize the thermal conductivity to the heat sink and the desired low compressive pressure to reduce the friction and mechanical stress on the semiconductor chips.

However, the aforementioned press-pack modules are prone to some general drawbacks. In the conventional press-pack module, there are often problems with non-uniform pressure distribution which in combination with large variations in clamping force may lead to insufficient heat transfer from of the chips. Whereas applying the clamping force by springs prevents symmetric cooling which leads to thermally induced bending of the package thereby causing reduced thermal heat transfer. Furthermore, the lifetime of power modules is mainly limited by the stress induced by thermal cycles, and since thermal cycling is inevitable, it is desirable to reduce the stress generated in the module.

There is therefore a need for a press-pack power module with improved cooling capability which at the same time fulfils requirements in terms of cost, size, weight, complexity, reliability and robustness.

### SUMMARY OF THE INVENTION

In view of the above-mentioned and other drawbacks of the prior art, a general object of the present invention is to improve the current state of the art and to mitigate at least one of the above mentioned problems.

This object is achieved by means of a semiconductor power module and a method for assembling a semiconductor power module as defined in the appended claims.

According to a first aspect of the present invention there is provided a semiconductor power module according to claim 1, comprising:
a first busbar and a second busbar;
at least one semiconductor chip sandwiched between said first busbar and said second busbar, together forming a module substructure, each semiconductor chip having at least one semiconductor component comprising a first electrode electrically connected to said first busbar and a second electrode electrically connected to said second busbar;
a first clamping structure comprising a first clamping body and a second clamping body each clamping body being disposed on opposite sides of said module substructure, wherein said clamping structure is arranged to press said first and second busbar towards each other along a first axis, in order to clamp said module substructure with a first clamping force thereby forming a press-pack module;
a second clamping structure comprising:
   two heat-sinks disposed on opposite sides of said press-pack module and wherein said second clamping structure is arranged to clamp said press-pack module by pressing said heat-sinks towards each other along a second axis perpendicular to said first axis with a second clamping force.

The presented semiconductor power module allows for improved long-term thermal performance, as compared to prior known solutions. Furthermore, the clamping forces (i.e. the clamping force of the first clamping structure and the clamping force of the second clamping structure) of the power module according to the invention are independent of each other and can therefore be individually optimized, thereby increasing reliability and robustness.

The term busbar (also known as bus bar, buss bar or bussbar) is readily recognized and known by the skilled artisan in the field of power electronics; however, it can be understood as a metallic bar (e.g. comprising copper) that conducts electricity within the semiconductor power module (may simply be referred to as power module in the following). In more detail, a busbar is a conductor or an assembly of conductors for collecting electric currents and distributing them to outgoing feeders, i.e. between components, inputs and outputs of the power module.

Further, the clamping structures may be any suitable clamping structure whereby an object (e.g. the module substructure or press-pack module) may be fixed and secured between two bodies, such as e.g. bar clamps, magnetic clamps, variations of pipe clamps, etc. For example, the first clamping structure may comprise a set of threaded rods arranged parallel to the first axis (second axis for the second clamping structure) with a set of correspondingly threaded nuts used to apply the first clamping force. In other words, the clamping structure may be pre-calibrated spring type clamps, which comprise a set of threaded nuts and rods, and may employ e.g. Belleville washers. Optionally, the clamping structures may comprise force indicators in order to ensure that the desired/required clamping forces are applied. In more detail, the first and second clamping bodies may accordingly be mechanically (physically) connected to each other so to apply pressure to the module substructure along the first axis from two opposite sides. Likewise, the two heat sinks may be mechanically (physically) connected to each other so to apply pressure to the press-pack module along the second axis from two opposite sides. However, the clamping bodies and two heat sinks may alternatively or additionally be directly or indirectly magnetically coupled to each other in order to generate the clamping forces along said first and/or second axis.

Moreover, the semiconductor component(s) arranged on the chip may be any suitable semiconductor component(s) as used in the art of power electronics, such a switching devices (e.g. IGBTs, MOSFETs, BJTs, thyristors, etc.) or other components, such as diodes. The semiconductor component(s) is/are preferably arranged on a planar die (or dice) as known in the art.

The heat-sinks are in the present context to be understood as devices that remove heat generated by the semiconductor chip(s) within the power module; preferably the heat is transferred to a fluid medium, such as air or liquid (e.g. water or oil). Thus, in an embodiment of the present invention, each of the two heat sinks further comprises at least one fluid channel (through which a fluid can run) in order to dissipate heat generated by the semiconductor power module. In addition to, or as an alternative for, the fluid channel(s) the heat-sinks may comprise fins. The heat-sinks preferably comprise a thermally conductive material such as e.g. copper or aluminum.

The present invention is based on the realization that by applying a second clamping structure perpendicular to the first clamping structure used to form a press-pack module, improved long-term thermal performance can be achieved, resulting in higher reliability and robustness of the semiconductor power module.

As discussed in the background section of the present application, there are two commonly used concepts for press-pack modules. However, each of the two concepts has their own inherent flaws and conventional power modules are prone to some general drawbacks in terms of complex manufacturing processes, insufficient cooling, long-term reliability issues, etc. Furthermore, conventional press-pack modules do not have the heat sinks electrically (galvanically) isolated from the module substructure, which complicates the system design. Furthermore, it prevents usage of water cooled heat sinks. Without any electrical insulation between the heat sinks and the module substructure a non-electrically conductive liquid (e.g. oil) must be used which will impair the cooling capability, or ultra-pure de-ionized water with a very high resistance must be used which increases complexity and costs.

Therefore, by clamping the module substructure with a first clamping force and subsequently clamping the formed press-pack module between a pair of heat-sinks many of the general drawbacks associated with prior known solutions can be overcome. The first clamping by means of the first clamping structure allows for good electrical contact between various components within the power module, and diminishes the need for soldering, sintering or connections by means of bond-wires. Further, the second clamping by means of the second clamping structure allows for a minimal thermal resistance between the formed press-pack module and the heat-sinks and provides for symmetrical cooling from both sides of the press-pack module. Also, due to the fact that a sufficiently high clamping force can be applied by the second clamping structure (i.e. on the heat-sinks) without affecting the clamping of the semiconductor chip(s), the need for thermal grease is significantly reduced, or could be replaced by a thin silicone oil. Thus, the cooling capability of the semiconductor power module can be maintained over the long-term operation, unlike prior known solutions where the thermal grease deteriorates and migrates over time.

Further, since the two clamping forces can be optimal and independent of each other, the module substructure in the present invention will expand and contract during thermal cycling and the clamping force acting on the chips will be virtually unaffected by the second clamping force (exerted by the second clamping structure). This is because so-called fully developed friction is achieved when the busbars expand and contract thermally, and thus, they are free floating during heating and cooling, despite being clamped between the heat sinks.

In other words, by means of the present invention the risk of the power module bending or between power cycles is reduced, which consequently increases the robustness of the power module. Also, the manufacturing or assembling of the power module is less complex and more cost-efficient due to the fact that the need for soldering or sintering is diminished.

Moreover, the module substructure can be adapted to commercial clamping structures with heat sinks used e.g. in the so-called Hockey-Puck diodes or thyristors, and thus, the second clamping structure can benefit from the lower manufacturing cost of the commercial clamping structures.

Further, the first clamping structure may be applied during manufacturing of the power module, and preferably at elevated temperatures, e.g. close to a targeted average operating temperature of the semiconductor chips. By clamping the module substructure (in order to form a press-pack module) already at a manufacturing stage of the module substructure the applied clamping force can be very precise, and it is also possible to measure the clamping force applied to each chip by e.g. advanced optical methods and thus, it is possible to ensure a low variation in the clamping force applied to individual chips in the power module. It is also possible during manufacturing to temporarily apply a very large clamping force in order to even out the contact area of the chips before the permanent clamping force is applied, and thus a more even pressure distribution can be obtained. Moreover, in an embodiment of the invention, the first and second electrodes of each semiconductor component comprises silver, and each of the busbars comprises corresponding contact portions comprising silver, the contact portions arranged to be in physical contact with the first and second electrode(s). This further increases robustness of the power module since silver arranged in contact with silver has a high friction component which prevents slipping (i.e. displacement of the corresponding contacts between the semiconductor component and second busbar). Additionally, it diminishes the need for using buffer layers such as e.g. molybdenum plates or at least allows for using thinner buffer layers albeit with improved heat transfer from the semiconductor chip(s) to the buffer layer.

Furthermore, in some embodiments the clamping structure may further comprise an electrically insulating member or layer between each heat-sink and the press-pack module. Hereby, the heat sinks can be electrically isolated from the press-pack module. This simplifies the overall system design and allows for free choice of cooling medium in the heat sinks, such as e.g. water. The electrically insulating (dielectric) layer may for example be a sheet or layer of Aluminum Nitride (AIN), alumina (aluminum oxide), Silicon Nitride (Si3N4), or any other similar material having high thermal conductivity and electrically insulating properties, in order to keep the thermal resistance between the module substructure and the heat sinks as low as possible. The thermal resistance between the heat sinks and the press-pack module is mainly controlled by the second clamping force whereby it can be maintained at a desired low level.

Electrically insulating body is in the present context to be understood as a body made of a material of such low conductivity that the flow of electric current through it is negligible.

Further, in accordance with yet another embodiment, the module substructure further comprises:
a first buffer layer arranged between each said semiconductor chip and said second busbar;
a second buffer layer arranged between each said semiconductor chip and said first busbar
wherein said first buffer layer and said second buffer layer have a thermal expansion coefficient that is a factor between 0.7 and 3.0 to that of the semiconductor chip(s). In other words, the thermal expansion coefficient of the buffer layers is close to that of the semiconductor chip(s).

The buffer layers arranged on opposite sides of the semiconductor chip help to mechanically stabilize the power module by reducing the mechanical stress in the semiconductor chips during thermal cycling. The buffer layers may for example be plates comprising molybdenum or tungsten arranged between the semiconductor chip(s) and the busbars. The semiconductor chip(s) are accordingly electrically connected to the busbars via the buffer layers in this embodiment.

Moreover, in accordance with another embodiment, the first electrode and the second electrode each comprises silver, and wherein the first buffer layer and the second buffer layer each comprises corresponding contact portions comprising silver, the corresponding contact portions being arranged in physical contact with the first and second electrode. The corresponding contact interfaces between the busbars and the buffer layers be silver-to-silver connections, i.e. the contact surfaces between the busbars and the buffer layers may comprise silver.

Even further, in an embodiment of the present invention, the at least one semiconductor component further comprises a gate electrode. The semiconductor component(s) may thus be switching devices, such as transistor(s) (e.g. MOSFETs or BJTs). Furthermore, the term gate electrode is selected without prejudice and includes the corresponding base electrode of a bipolar transistor.

Even further, in accordance with an embodiment of the present invention, wherein the first busbar or the second busbar comprises at least one gate probe arranged within the first busbar or the second busbar (respectively) and wherein the at least one gate probe is electrically connected to the gate/base electrode. The gate probes further diminish the need of soldering, sintering or employing bond-wires for providing electrical connections between a gate/base driver circuit and the gate/base electrodes of the semiconductor component(s). Each gate probe preferably comprises elongated structures disposed within the first busbar and arranged to be in contact with the gate electrode of each semiconductor component. The gate probes are also electrically isolated from the first busbar.

Further, in accordance with another embodiment of the present invention each of the gate probes includes a spring contact portion for providing a biasing force against each of the first electrodes. This further ensures reliable gate connections within the power module. Moreover, the biasing force by which each gate probe is pressing on the gate electrode is independent of the clamping forces. Thus, the biasing force can be predetermined and selected in accordance with desired specifications, since it is at least partly decoupled/independent from the first clamping force. Moreover, in the embodiment where the semiconductor power module comprises buffer layers, the second buffer layer may be provided with an opening through which a portion of each gate probe extends.

Even further, in accordance with yet another embodiment of the present invention, the semiconductor power module further comprises a plurality of spring elements arranged between each of the first and second clamping bodies and the module substructure in order to provide an even pressure distribution of the first clamping force. The spring elements may for example be Belleville washers (also known as coned disc springs, conical spring washer, disc springs, Belleville springs, etc.). The spring elements according to an embodiment of the invention are not used as connecting means or connectors as in prior art but serve to provide an even pressure distribution of the first clamping force on each semiconductor chip of the power module. The spring elements also help to ensure that the first clamping force applied on the module substructure is maintained throughout the lifetime of the semiconductor power module. Moreover, first clamping force may be applied at elevated temperatures, but not above the operating temperature of the semiconductor chip(s), during manufacturing or assembly of the press-pack module. Further, in accordance with another aspect of the present invention there is provided a method for assembling a semiconductor power module according to claim 11. The method comprises:
providing a module substructure according to any embodiment of the previous aspect of the invention;
providing a first clamping structure comprising a first clamping body and a second clamping body;
clamping the module substructure between the first clamping body and the second clamping body in order to press the first busbar and the second busbar towards each other along a first axis with a first clamping force, thereby forming a press-pack module;
clamping the press-pack module between two heat-sinks along a second axis perpendicular to the first axis with a second clamping force.

By clamping the module substructure during manufacturing first clamping force can be applied with high precision and also at elevated temperature. In some embodiments, the method includes performing the clamping of the module substructure at predefined temperature close to the operating temperature of the semiconductor component(s)/chip(s), the tensile stress on the semiconductor chip(s) caused by thermal mismatch is reduced, making for a robust and reliable power module. The second clamping force is independent from the first clamping force.

Thus, in an embodiment of the invention the clamping of the module substructure between the first clamping body and the second clamping body is performed at a temperature within the range of ± 20 K from the average target operating temperature of the semiconductor chip(s). For example, if the average target (or targeted average) operating temperature of the chip(s) is 100 °C, the first clamping is done at a temperature within the range of 80 °C to 120 °C.

In accordance with an embodiment of the invention, the first clamping force results in an applied surface pressure on the semiconductor chip(s) in the range of 5 MPa to 60 MPa, preferably in the range of 15 MPa to 45 MPa and most preferably in the range of 20 MPa to 30 MPa. The applied surface pressure is to be construed as a clamping pressure/"sandwiching" pressure, i.e. applied on both sides of the semiconductor chip(s).

Further, in accordance with another embodiment of the present invention, the second clamping force results in an applied surface pressure on said press-pack module in the range of 10 MPa to 100 MPa, preferably in the range of 15 MPa to 60 MPa and most preferably in the range of 20 MPa to 30 MPa. The clamping forces are presented as a resulting surface pressure since the actual applied clamping force depends on the dimensions of the various parts of the module substructure/press-pack module, and it is generally the applied surface pressure which one desires to control. Similarly, the second clamping force results in an applied surface pressure that is to be construed as a clamping/"sandwiching" pressure, i.e. applied on both sides of the press-pack modules.

Further effects and features of this aspect of the present invention are largely analogous to those described above in connection with the first aspect of the invention, and vice versa.

Further features of, and advantages with, the present invention will become apparent when studying the appended claims and the following description.

### BRIEF DESCRIPTION OF THE DRAWINGS

These and other aspects of the present invention will now be described in more detail, with reference to the appended drawings showing a currently preferred embodiment of the invention, wherein:
Fig. 1 is a partly exploded perspective view of a semiconductor power module in accordance with an embodiment of the present invention.
Fig. 2 is an exploded view of a press-pack module in accordance with an embodiment of the present invention.
Fig. 3 is an exploded view of a press-pack module in accordance with another embodiment of the present invention.
Fig. 4 is a perspective view of the press-pack module in Fig. 3 with a cut-out view of the first busbars in accordance with an embodiment of the present invention.
Fig. 5 is an exploded perspective view of a press-pack module in accordance with another embodiment of the present invention.
Fig. 6 is a schematic flow-chart illustrating a method for assembling a semiconductor power module in accordance with an embodiment of the present invention.

### DETAILED DESCRIPTION

In the following detailed description, preferred embodiments of the present invention will be described. However, it is to be understood that features of the different embodiments are exchangeable between the embodiments and may be combined in different ways, unless anything else is specifically indicated. Even though in the following description, numerous specific details are set forth to provide a more thorough understanding of the present invention, it will be apparent to one skilled in the art that the present invention may be practiced without these specific details. In other instances, well known constructions or functions are not described in detail, so as not to obscure the present invention.

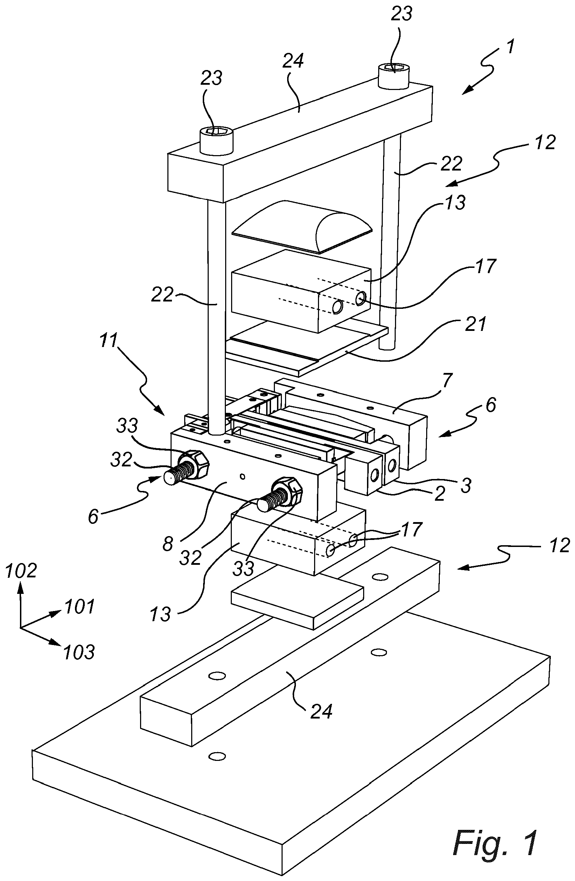

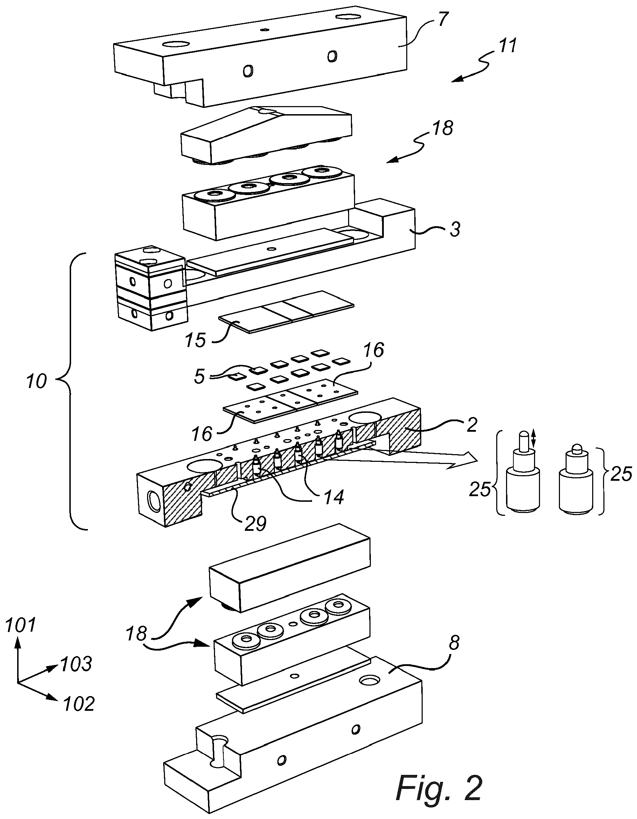

In Fig. 1 a partly exploded view of a semiconductor power module 1 is illustrated. The power module 1 has a set of busbars 2, 3 with a plurality of semiconductor chips sandwiched in between which together form a module substructure (e.g. ref. 10 in Fig. 2). Further details of the module substructure and the press-pack module will be provided in reference to figures 2-4.

The module substructure is in turn clamped by means of a first clamping structure 6 between a first clamping body 7 and a second clamping body 8 thereby forming a press-pack module 11. The first and second clamping bodies 7, 8 (may be referred to as yokes) are disposed on opposite sides of the module substructure along a first axis 101 (sometimes referred to as a stacking axis). The module substructure is pressed by means of two longitudinal at least partly threaded rods 32 extending along the first axis 101 and a set of threaded bolts 33. The module substructure may then accordingly be pressed such that an applied surface pressure on the semiconductor chip(s) reaches a predefined desirable level, e.g. in the range of 5 MPa to 60 MPa. The first and second clamping bodies 7, 8 of the first clamping structure, as well as the elongated threaded rods or screws 33 may be electrically isolated from the busbars 2, 3 depending on the intended application.

Further, Fig.1 shows a second clamping structure 12 having two heat sinks 13 disposed on opposite sides of the press-pack module 11. The second clamping structure 12 is arranged to clamp the press-pack module 11 between the two heat sinks 13 along a second axis 102, the second axis 102 being perpendicular to the first axis 101 (as indicated by the Cartesian coordinate system to the left of the drawing). There are further two layers of electrically insulating material 21 (e.g. aluminum nitride, AIN) arranged between the heat sinks 13 and the press-pack module 11, in order to electrically isolate the heat sinks 13 from the module substructure 6. Only one of the electrically insulting layers 21 is shown in the figure. The electric isolation between the heat sinks 13 and the press-pack module 11 reduces the risk of short-circuiting the power module 1. The heat sinks 13 further have a pair of fluid channels 17 through which a fluid (e.g. oil or water) can run in order to dissipate heat generated by the semiconductor power module.

The second clamping structure 12 is here illustrated as a conventional clamping arrangement, similar to the first clamping structure 6, having two rods 22 equally spread around the press-pack module 11 and having two yokes 24 arranged on each side of the press-pack module 11, to enclose the same between the heat sinks 13. The clamping yokes 24 and the rods 22 may be electrically isolated from the module substructure 6. However, the general clamping of the press-pack structure as well as the clamping of module substructure, i.e. the first and second clamping structures, are considered to be readily understood by the skilled artisan, and is for example disclosed in WO 2014/086427, incorporated herein by reference, and further details will for the sake of brevity be omitted in the following description.

By clamping the module substructure with a first clamping force and subsequently clamping the formed press-pack module 11 between a pair of heat-sinks 13 along a perpendicular axis 102 with respect to the first clamping axis 101, many of the general drawbacks associated with prior known solutions can be overcome. The first clamping, i.e. the clamping of the module substructure can be optimized with regard to electrical and thermal contact within the module substructure and reduce the risk of exceeding the mechanical strength of the chips during operation. Moreover, the second clamping by means of the second clamping structure 12 can be optimized for a minimal thermal resistance between the formed press-pack module 11 and the heat-sinks versus weight, size and cost for the clamping structure. The second clamping provides also symmetrical cooling from both sides of the module substructure. The symmetrical cooling improves the cooling of the module substructure and eliminates thermally induced bending of the press-pack module 11. Moreover, the module substructure can be adapted to commercial clamping structures with heat sinks used e.g. in the so-called Hockey-Puck diodes or thyristors, and thus, the second clamping structure 12 can benefit from the lower manufacturing cost of the commercial clamping structures

In Fig. 2 an exploded perspective view of a press-pack module 11, in accordance with an embodiment of the present invention, is illustrated. For clarification, the press-pack module 11 is a sub assembly of the semiconductor power module 1, in other words; it is the semiconductor power module 1 in Fig. 1 module without the second clamping structure 12.

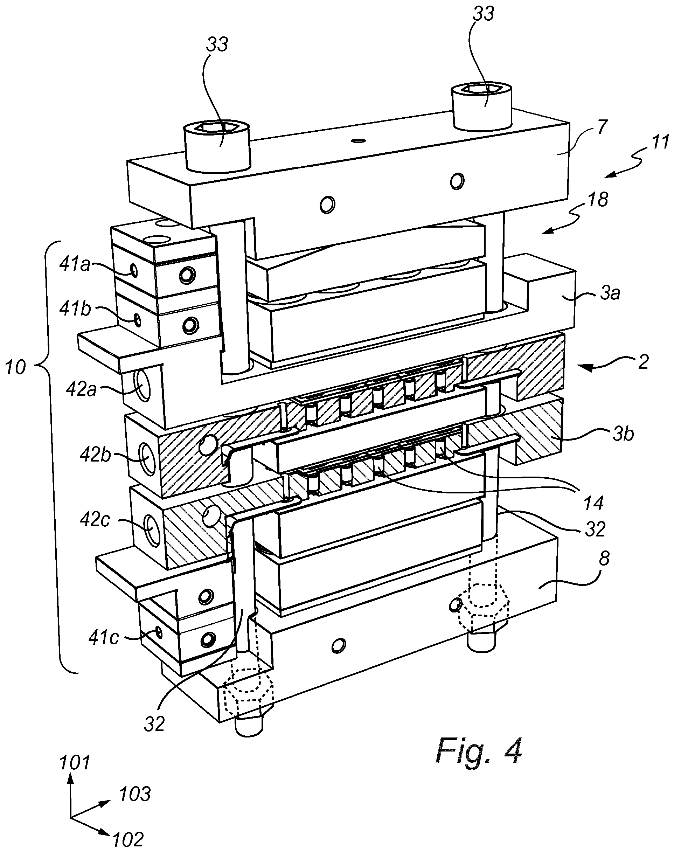

However, in Fig. 2 the structure of the press-pack module 11 can be seen in more detail. There is a set of semiconductor chips 5, comprising one or more semiconductor components (not shown). Each of the semiconductor components has a first electrode (not shown) in electrical contact with the first busbar 2 and a second electrode arranged in electrical contact with the second busbar 3. For example, if the semiconductor component is a diode, one of the anode or cathode is electrically connected to the first busbar 2 and the other one of the anode or cathode is electrically connected to the second busbar. Continuingly, if the semiconductor component is a transistor (MOSFET, BJT, IGBT, etc.) the source/emitter electrode of the transistor can be connected to the first busbar 2 and the drain/collector electrode of the transistor can be connected to the second busbar 3. Moreover, in the case of the semiconductor component being a transistor, the gate/base electrode can be electrically connected to a gate/base driver circuit via a gate probe 14 arranged within the first busbar 2, or more specifically via a spring contact portion of the gate probe 14. The gate probes 14 are subsequently connected to a properly traced circuit board 29 and further to a gate/base driver circuit via e.g. an electrical contact/input (see 41a-c in Fig. 4). The biasing aspect of the spring contact portion is indicated in the cutout 25, where it is shown how the gate probe provides a biasing force against each of the gate electrodes. Hereby, the pressure acting upon the gate/base electrodes may be decoupled from the first clamping force and the need for soldering or sintering connections is further diminished. The spring contact portions are electrically isolated from the busbar in which the gate probes are positioned within.

The semiconductor chips 5 are sandwiched between the first busbar 2 and the second busbar 3, together forming a module substructure 10. Though, in the illustrated embodiment the semiconductor chips 5 are first sandwiched between a first buffer layer 15 and a second buffer layer 16. The first and second buffer layers 15, 16 may for example be rhodium coated molybdenum discs or plates, which reduce the mechanical stress caused by thermal mismatch between the (copper) busbars 2, 3 and the semiconductor chips 5.

Further, the first and second clamping bodies 7, 8 of the clamping structure are shown. The clamping bodies 7, 8 are disposed on opposite sides of the module substructure 10 and arranged to press the first busbar 2 and the second busbar 3 towards each other along a first axis 101 (may also be referred to as a stacking axis). This is in order to clamp the module substructure 10 with a first clamping force and thereby form a press-pack module 11. Moreover, there are through holes or openings in the clamping bodies 7, 8 as well as the busbars 2, 3 through which a pair of threaded rods (illustrated in Fig. 4) may be arranged.

Even further, the press-pack module 11 comprises a set of spring elements 18 arranged between the first and second clamping bodies 7, 8 and the module substructure 10. The spring elements 18 may for example be Belleville washers or similar. Their purpose is to maintain more constant clamping force over the chips during thermal expansion and contraction, and also to avoid reduction of the clamping force due to relaxation over long-term operation

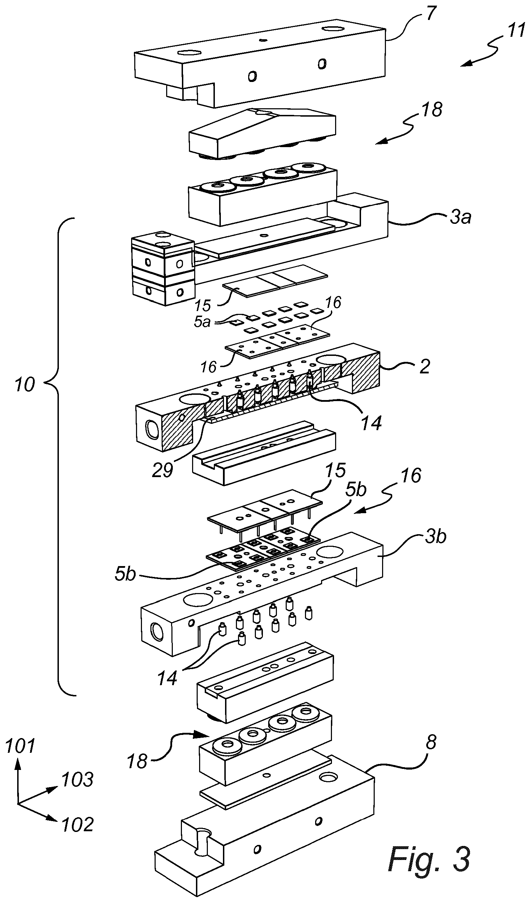

Fig. 3 illustrates a press-pack module of a semiconductor power module in accordance with another embodiment of the invention. This embodiment is similar to the embodiment illustrated in Fig. 2 wherefore many elements and features are largely analogous and will not be further discussed. However, Fig. 3 illustrates a stacking assembly where a plurality of semiconductor chips is arranged in two layers stacked along the first axis 101. For example, in a half bridge implementation of the power module, the top-most busbar 3a would be connected to a positive DC terminal, the intermediate busbar 2 would be connected to the phase terminal, and the lower busbar 3b would be connected to a negative DC terminal of a half-bridge converter. Continuingly, the semiconductor chips 5a,b comprise transistors arranged between the busbars in the half-bridge converter, and more specifically the transistors would be arranged such that the "upper" transistors (arranged on chips 5a) would have their drain/collector electrodes electrically connected to the top-most busbar 3a (DC+) and their source/emitter electrodes connected to the intermediate busbar 2 (Phase), while the "lower" transistors (arranged on chips 5b) would have their drain/collector electrodes connected to the intermediate busbar 2 (Phase) and their source/emitter electrodes electrically connected to the lower busbar 3b (DC-). The gate electrodes of the transistors 5a,b are connected to a respective gate drive circuit (not shown) via the gate probes 14. Thus, in this configuration the two separate layers of semiconductor chips 5a,b share a common busbar 2.

Further, in Fig. 4 the press-pack module 11 from Fig. 3 in a stacked and assembled configuration. In this figure the first clamping structure is illustrated, the first clamping structure having parallel rods 32 extending through the clamping bodies 7, 8 along the first axis 101. Moreover, a number of external electrical contacts 41a-c, 42a-c of the power module are illustrated.

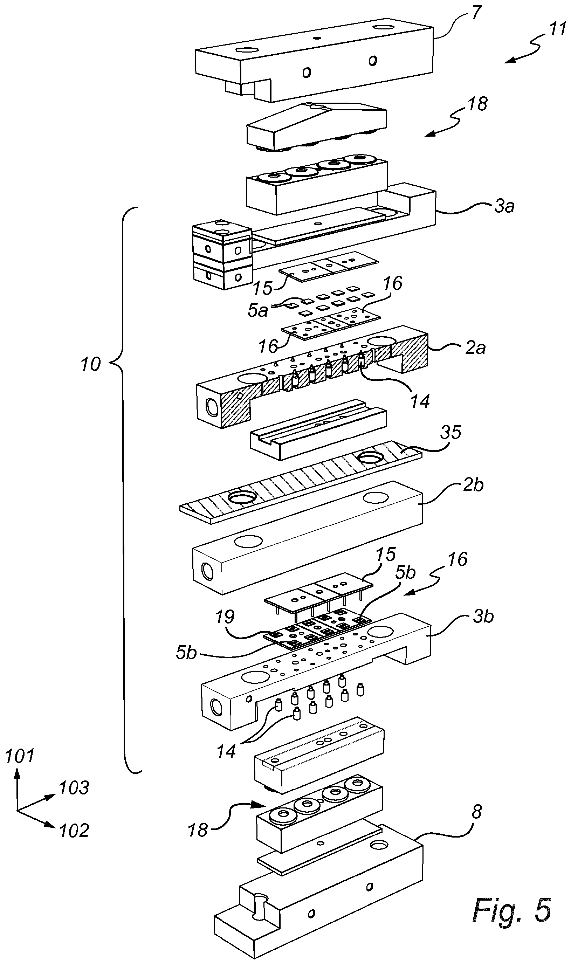

Fig. 5 shows another embodiment of the invention with four busbars 2a, 2b, 3a, 3b in the module substructure 11 in order to illustrate another electrical implementation of the power module. In this embodiment, the two "outer" busbars 3a, 3b may be connected to a phase terminal. Further, one of the intermediate busbars 2a may be connected to a positive DC terminal, and the other one of the intermediate busbars 2b may be connected to a negative DC terminal. In this configuration there must be electrical insulation 35 between the DC busbars 2a, 2b. In other words, the "phase busbars" 3a, 3b are placed on both sides of the DC busbars 2a, 2b with the chips sandwiched between them and the DC busbars 2a, 2b.

By combining the three different arrangements of the module substructure illustrated in Figs. 2-5 in various ways, the semiconductor power module of the invention can be adapted for a wide variety of power electronic applications, as will be readily understood and appreciated by the skilled artisan.

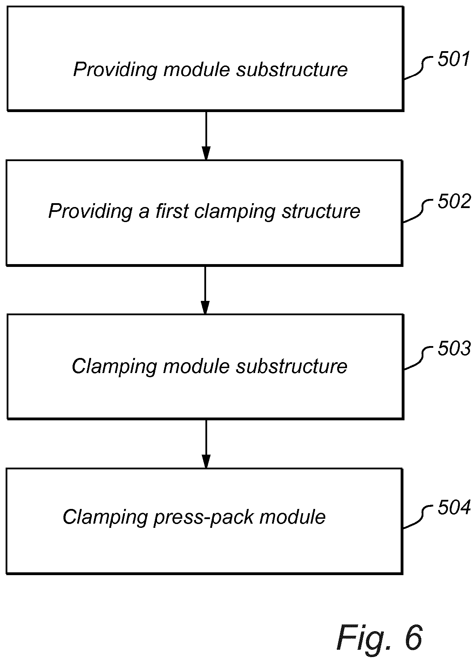

Fig. 6 shows a schematic flow chart of a method for assembling a semiconductor power module in accordance with an embodiment of the invention. Firstly, a module substructure having at least one semiconductor chip sandwiched between a first busbar and a second busbar is provided 501. Further, a first clamping structure having a first clamping body and a second clamping body is provided 502.

Continuingly, the module substructure is clamped 503 between the first clamping body and the second clamping body in order to form a press-pack module. Preferably, this clamping step 503 is performed at elevated temperature, being at least close to that of an average target operating temperature of the semiconductor chip(s) within the module substructure. For example, the clamping 503 may be performed at a temperature in the range of ± 20 K from the average target operating temperature of the semiconductor chip(s). The average target (or targeted average) operating temperature, is a term readily known and understood by the skilled artisan and will not for the sake of brevity be further discussed, it is also readily deductible from e.g. a chip specification sheet.

Furthermore, in some embodiments the clamping 503 of the module substructure may be performed at even further elevated temperatures, above the maximum operating temperature of the semiconductor chip(s), such that silver may be used as contact material for both the semiconductor and the busbars. In other words, the electrodes of the semiconductor component and the corresponding contact portions of the busbars may comprise silver. Using silver as contact material in combination with the high clamping force applied during the clamping 503 reduces the risk of slip. Moreover, the clamping 503 at elevated temperatures reduces tensile stress on the semiconductor chip(s) caused by thermal mismatch within the power module. Thus by means of the present invention it is possible to deviate from the "free floating technology" where buffer layers are used, and instead utilize silver-to-silver contacts by assembling the press-pack module at elevated temperatures, above the maximum operating temperature of the semiconductor chip(s) and by clamping with a pressing force resulting in an applied surface pressure on the semiconductor chip(s) in the range of 20 MPa to 60 MPa.

Further, the press-pack module is clamped 504 between two heat-sinks along a second axis which is perpendicular to the first axis with a second clamping force. By clamping 504 the press-pack module between two heat-sinks a low thermal resistance between from the press-pack module and the heat-sinks is ensured and efficient and symmetrical cooling can be achieved. Moreover, the low thermal resistance can hereby be ensured for a longer period of time (e.g. for the full lifetime of the power module) as compared to prior known power modules, since the thermal resistance does not depend on the presence of thermal grease or the condition of the same, which is affected by thermal cycling.

The first clamping force is preferably such that it results in an applied surface pressure on the semiconductor chip(s) in the range of 5 MPa to 60 MPa. The reason as to why the force is defined as a resulting surface pressure on the chip(s) is that, a specific surface pressure is the desired effect which is predetermined, and consequently the applied clamping force will depend on the dimensions of the various parts of the power module (e.g. chip area, number of chips, etc.). Accordingly, the predefined second clamping force is preferably such that it results in an applied surface pressure on the press-pack module in the range of 10 MPa to 100 MPa. For example, the power module may have the following specifications:

| | |
|---|---|
| Type of chips: | MOSFET |
| Chip area: | 5×5 = 25 mm2 |
| Source/Emitter area: | 20 mm2 |
| Number of chips per switch: | 10 |
| Total area emitter area per switch: | 200 mm2 |
| Type of power module: | half bridge |
| Area of the heat sink in contact with the module substructure: | 2000 mm2 |

An applied surface pressure on the source/emitter area of 25 MPa will require a clamping force of 5 kN, while a pressure on the heat sinks in contact with the press-pack module (or module substructure) of 20 MPa will require a clamping force of 40 kN.

In the claims, the word "comprising" does not exclude other elements or steps, and the indefinite article "a" or "an" does not exclude a plurality.

## Claims

1. A semiconductor power module (1), comprising:
a first busbar (2) and a second busbar (3);
at least one semiconductor chip (5) sandwiched between said first busbar (2) and said second busbar (3), together forming a module substructure (10), each semiconductor chip of said at least one semiconductor chip (5) having at least one semiconductor component comprising a first electrode electrically connected to said first busbar (2) and a second electrode electrically connected to said second busbar (3);
a first clamping structure (6) comprising a first clamping body (7) and a second clamping body (8) each clamping body being disposed on opposite sides of said module substructure (10) along a first axis, wherein said clamping structure is arranged to press said first busbar and said second busbar towards each other along said first axis (101), in order to clamp said module substructure with a first clamping force thereby forming a press-pack module (11);
a second clamping structure (12) comprising:
two heat-sinks (13) disposed on opposite sides of said press-pack module (11) along a second axis perpendicular to said first axis and wherein said second clamping structure (12) is arranged to clamp said press-pack module (11) by pressing said heat-sinks (13) towards each other along said second axis (102) perpendicular to said first axis (101) with a second clamping force.

2. The semiconductor power module (1) according to claim 1, wherein said first electrode and said second electrode each comprises silver, and wherein said first busbar (2) and said second busbar (3) each comprises corresponding contact portions comprising silver, said corresponding contact portions being arranged in physical contact with said first and second electrode.

3. The semiconductor power module (1) according to claim 1, wherein said module substructure (10) further comprises:
a first buffer layer (15) arranged between each said semiconductor chip (5) and said second busbar (3);
a second buffer layer (16) arranged between each said semiconductor chip (5) and said first busbar (2)
wherein said first buffer layer and said second buffer layer have a thermal expansion coefficient that is a factor between 0.7 and 3.0 to that of the semiconductor chip(s).

4. The semiconductor power module (1) according to claim 3, wherein said first electrode and said second electrode each comprises silver, and wherein said first buffer layer (15) and said second buffer layer (16) each comprises corresponding contact portions comprising silver, said corresponding contact portions being arranged in physical contact with said first and second electrode.

5. The semiconductor power module (1) according to any one of the preceding claims, wherein said at least one semiconductor component further comprises a gate electrode.

6. The semiconductor power module (1) according to claim 5, wherein one of said first busbar (2) or second busbar (2) comprises at least one gate probe (14) arranged within said first busbar (2) or said second busbar (3) and wherein said at least one gate probe is electrically connected to said gate electrode.

7. The semiconductor power module (1) according to claim 6, wherein said gate probe (14) includes a spring contact portion for providing a biasing force against said gate electrode.

8. The semiconductor power module (1) according to any one of the preceding claims, further comprising a plurality of spring elements (18) arranged between each of said first and second clamping bodies (7, 8) and the module substructure (10) in order to provide and maintain an even pressure distribution of said first clamping force.

9. The semiconductor power module (1) according to any one of the preceding claims, wherein said second clamping structure further comprises an electrically insulating layer arranged between each of said two heat sinks (13) and said press-pack module in order to electrically isolate said press-pack module (11) from said two heat sinks (13).

10. The semiconductor power module according to any one of the preceding claims, wherein each of said two heat sinks (13) comprises at least one fluid channel (17).

11. Method for assembling a semiconductor power module according to any one of claims 1-9 comprising:
providing (501) the module substructure (10) of a semiconductor power module according to any one of claims 1- 9;
providing (502) a first clamping structure (6) comprising a first clamping body (7) and a second clamping body (8);
clamping (503) said module substructure between said first clamping body and said second clamping body in order to press the first busbar (2) and the second busbar (3) towards each other along a first axis (101) with a first clamping force, thereby forming a press-pack module (11);
clamping (504) said press-pack module (11) between two heat-sinks along a second axis (102) perpendicular to said first axis (101) with a second clamping force.

12. The method according to claim 11, wherein said clamping (503) said module substructure between said first clamping body and said second clamping body is performed at a temperature within the range of ± 20 K from the target average operating temperature of said semiconductor chip(s).

13. The method according to claim 11 or 12, wherein said first clamping force results in an applied surface pressure on each semiconductor chip of said at least one semiconductor chip (5) in the range of 5 MPa to 60 MPa, preferably in the range of 15 MPa to 45 MPa and most preferably in the range of 20 MPa to 30 MPa.

14. The method according to any one of claims 11 to 13, wherein said second clamping force results in an applied surface pressure on said press-pack module in the range of 10 MPa to 100 MPa, preferably in the range of 15 MPa to 60 MPa and most preferably in the range of 20 MPa to 30 MPa.

## Patentansprüche

1. Halbleiterleistungsmodul (1), umfassend:
eine erste Sammelschiene (2) und eine zweite Sammelschiene (3);
mindestens einen Halbleiterchip (5), der zwischen der ersten Sammelschiene (2) und der zweiten Sammelschiene (3) angeordnet ist und zusammen eine Modulunterstruktur (10) bildet wobei jeder Halbleiterchip des mindestens einen Halbleiterchips (5) mindestens eine Halbleiterkomponente aufweist, umfassend eine erste Elektrode, die elektrisch mit der ersten Sammelschiene (2) verbunden ist, und eine zweite Elektrode, die elektrisch mit der zweiten Sammelschiene (3) verbunden ist;
eine erste Klemmstruktur (6), umfassend einen ersten Klemmkörper (7) und einen zweiten Klemmkörper (8), wobei jeder Klemmkörper auf gegenüberliegenden Seiten der Modulunterstruktur (10), entlang einer ersten Achse angeordnet ist, wobei die Klemmstruktur so angeordnet ist, dass sie die erste Sammelschiene und die zweite Sammelschiene entlang einer ersten Achse (101) zueinander hin drückt, um die Modulunterstruktur mit einer ersten Klemmkraft zu klemmen, wodurch ein Presspackmodul (11) gebildet wird;
eine zweite Klemmstruktur (12), umfassend:
zwei Kühlkörper (13), die auf gegenüberliegenden Seiten des Presspackmoduls (11) entlang einer zweiten Achse (102) senkrecht zu der ersten Achse (101) angeordnet sind und wobei die zweite Klemmstruktur (12) so angeordnet ist, dass sie das Presspackmodul (11) durch Pressen der Kühlkörper (13) zueinander entlang der zweiten Achse (102), senkrecht zu der ersten Achse (101), mit einer zweiten Klemmkraft klemmt.

2. Halbleiterleistungsmodul (1) nach Anspruch 1, wobei die erste Elektrode und die zweite Elektrode jeweils Silber umfassen und wobei die erste Sammelschiene (2) und die zweite Sammelschiene (3) jeweils entsprechende Kontaktabschnitte umfassen, die Silber umfassen, wobei die entsprechenden Kontaktabschnitte in physikalischem Kontakt mit der ersten und zweiten Elektrode angeordnet sind.

3. Halbleiterleistungsmodul (1) nach Anspruch 1, wobei die Modulunterstruktur (10) ferner umfasst:
eine erste Pufferschicht (15), die zwischen jedem Halbleiterchip (5) und der zweiten Sammelschiene (3) angeordnet ist;
eine zweite Pufferschicht (16), die zwischen jedem Halbleiterchip (5) und der ersten Sammelschiene (2) angeordnet ist
wobei die erste Pufferschicht und die zweite Pufferschicht einen Wärmeausdehnungskoeffizienten, der ein Faktor zwischen 0,7 und 3,0 zu dem des Halbleiterchips (der Halbleiterchips) ist, aufweisen.

4. Halbleiterleistungsmodul (1) nach Anspruch 3, wobei die erste Elektrode und die zweite Elektrode jeweils Silber umfassen und wobei die erste Pufferschicht (15) und die zweite Pufferschicht (16) jeweils entsprechende Kontaktabschnitte umfassen, die Silber umfassen, wobei die entsprechenden Kontaktabschnitte in physikalischem Kontakt mit der ersten und zweiten Elektrode angeordnet sind.

5. Halbleiterleistungsmodul (1) nach einem der vorhergehenden Ansprüche, wobei die mindestens eine Halbleiterkomponente ferner eine Gate-elektrode umfasst.

6. Halbleiterleistungsmodul (1) nach Anspruch 5, wobei eine der ersten Sammelschienen (2) oder zweiten Sammelschienen (2) mindestens eine Gate-sonde (14) umfasst, die in der ersten Sammelschiene (2) oder der zweiten Sammelschiene (3) angeordnet ist und wobei die mindestens eine Gate-sonde elektrisch mit der Gate-elektrode verbunden ist.

7. Halbleiterleistungsmodul (1) nach Anspruch 6, wobei die Gate-Sonde (14) einen Federkontaktabschnitt zum Bereitstellen einer Vorspannkraft gegen die Gate-elektrode enthält.

8. Halbleiterleistungsmodul (1) nach einem der vorhergehenden Ansprüche, ferner umfassend eine Mehrzahl an Federelemente (18), die zwischen jedem der ersten und zweiten Klemmkörper (7, 8) und der Modulunterstruktur (10) angeordnet sind um eine gleichmäßige Druckverteilung der ersten Klemmkraft bereitzustellen und aufrechtzuerhalten.

9. Halbleiterleistungsmodul (1) nach einem der vorhergehenden Ansprüche, wobei die zweite Klemmstruktur ferner eine elektrisch isolierende Schicht umfasst, die zwischen jedem der beiden Kühlkörper (13) und dem Presspackmodul angeordnet ist, um das Presspackmodul von den beiden Kühlkörpern (13) elektrisch zu isolieren.

10. Halbleiterleistungsmodul nach einem der vorhergehenden Ansprüche, wobei jeder der beiden Kühlkörper (13) mindestens einen Fluidkanal (17) umfasst.

11. Verfahren zum Zusammenbau eines Halbleiterleistungsmoduls, nach einem der Ansprüche 1 bis 9, umfassend:
Bereitstellen (501) der Modulunterstruktur (10) nach einem der Ansprüche 1 bis 9;
Bereitstellen (502) einer ersten Klemmstruktur (6), umfassend einen ersten Klemmkörper (7) und einen zweiten Klemmkörper (8);
Klemmen (503) der Modulunterstruktur zwischen dem ersten Klemmkörper und dem zweiten Klemmkörper, um die erste Sammelschiene (2) und die zweite Sammelschiene (3) entlang einer ersten Achse (101) mit einer ersten Klemmkraft zueinander zu drücken, wodurch ein Presspackmodul (11) gebildet wird;
Klemmen (504) des Presspackmoduls (11) zwischen zwei Kühlkörpern entlang einer zweiten Achse (102) senkrecht zu der ersten Achse (101) mit einer zweiten Klemmkraft.

12. Verfahren nach Anspruch 11, wobei das Klemmen (503) der Modulunterstruktur zwischen dem ersten Klemmkörper und dem zweiten Klemmkörper bei einer Temperatur im Bereich von ± 20 K von der durchschnittlichen Zielbetriebstemperatur des Halbleiterchips (der Halbleiterchips) (503) durchgeführt wird.

13. Verfahren nach Anspruch 11 oder 12, wobei die erste Klemmkraft zu einem auf jeden Halbleiterchip der mindestens einen Halbleiterchips ausgeübten Oberflächendruck im Bereich von 5 MPa bis 60 MPa, vorzugsweise im Bereich von 15 MPa bis 45 MPa und den bevorzugtesten im Bereich von 20 MPa bis 30 MPa, führt.

14. Verfahren nach einem der Ansprüche 1 bis 13, wobei die zweite Klemmkraft zu einem auf das Presspackmodul ausgeübten Oberflächendruck im Bereich von 10 MPa bis 100 MPa, vorzugsweise im Bereich von 15 MPa bis 60 MPa und am bevorzugtesten im Bereich von 20 MPa bis 30 MPa ,führt.

## Revendications

1. Module de puissance à semi-conducteur (1), comprenant :
une première barre omnibus (2) et une deuxième barre omnibus (3) ;
au moins une puce semi-conductrice (5) prise en sandwich entre ladite première barre omnibus (2) et ladite deuxième barre omnibus (3), formant ensemble une sous-structure de module (10), chaque puce semi-conductrice de ladite au moins une puce semi-conductrice (5) ayant au moins un composant semi-conducteur comprenant une première électrode connectée électriquement à ladite première barre omnibus (2) et une deuxième électrode connectée électriquement à ladite deuxième barre omnibus (3) ;
une première structure de serrage (6) comprenant un premier corps de serrage (7) et un deuxième corps de serrage (8), chaque corps de serrage étant disposé sur des côtés opposés de ladite sous-structure de module (10) le long d'un premier axe, ladite structure de serrage étant agencée pour presser ladite première barre omnibus et ladite deuxième barre omnibus l'une vers l'autre le long dudit premier axe (101), afin de serrer ladite sous-structure de module avec une première force de serrage, formant ainsi un module press-pack (11) ;
une deuxième structure de serrage (12) comprenant :
deux dissipateurs thermiques (13) disposés sur des côtés opposés dudit module press-pack (11) le long d'un deuxième axe perpendiculaire audit premier axe et où ladite deuxième structure de serrage (12) est agencée pour serrer ledit module presse-pack (11) en pressant lesdits dissipateurs thermiques (13) l'un vers l'autre le long dudit deuxième axe (102) perpendiculaire audit premier axe (101) avec une deuxième force de serrage.

2. Module de puissance à semi-conducteur (1) selon la revendication 1, dans lequel ladite première électrode et ladite deuxième électrode comprennent chacune de l'argent, et dans lequel ladite première barre omnibus (2) et ladite deuxième barre omnibus (3) comprennent chacune des parties de contact correspondantes comprenant de l'argent, lesdites parties de contact correspondantes étant disposées en contact physique avec lesdites première et deuxième électrodes.

3. Module de puissance à semi-conducteur (1) selon la revendication 1, dans lequel ladite sous-structure de module (10) comprend en outre :
une première couche tampon (15) disposée entre chaque dite puce semi-conductrice (5) et ladite deuxième barre omnibus (3) ;
une deuxième couche tampon (16) disposée entre chaque dite puce semi-conductrice (5) et ladite première barre omnibus (2)
dans lequel ladite première couche tampon et ladite deuxième couche tampon ont un coefficient de dilatation thermique qui est un facteur compris entre 0,7 et 3,0 par rapport à celui de la ou des puces semi-conductrices.

4. Module de puissance à semi-conducteur (1) selon la revendication 3, dans lequel ladite première électrode et ladite deuxième électrode comprennent chacune de l'argent, et dans lequel ladite première couche tampon (15) et ladite deuxième couche tampon (16) comprennent chacune des parties de contact correspondantes comprenant de l'argent, lesdites parties de contact correspondantes étant disposées en contact physique avec lesdites première et deuxième électrodes.

5. Module de puissance à semi-conducteur (1) selon l'une quelconque des revendications précédentes, dans lequel ledit au moins un composant à semi-conducteur comprend en outre une électrode de grille.

6. Module de puissance à semi-conducteur (1) selon la revendication 5, dans lequel l'une desdites première barre omnibus (2) ou deuxième barre omnibus (2) comprend au moins une sonde de grille (14) agencée au sein de ladite première barre omnibus (2) ou de ladite deuxième barre omnibus (3) et dans lequel ladite au moins une sonde de grille est électriquement connectée à ladite électrode de grille.

7. Module de puissance à semi-conducteur (1) selon la revendication 6, dans lequel ladite sonde de grille (14) comprend une partie de contact à ressort pour fournir une force de sollicitation contre ladite électrode de grille.

8. Module de puissance à semi-conducteur (1) selon l'une quelconque des revendications précédentes, comprenant en outre une pluralité d'éléments à ressort (18) disposés entre chacun desdits premier et deuxième corps de serrage (7, 8) et la sous-structure de module (10) afin de fournir et maintenir une répartition uniforme de pression de ladite première force de serrage.

9. Module de puissance à semi-conducteur (1) selon l'une quelconque des revendications précédentes, dans lequel ladite deuxième structure de serrage comprend en outre une couche électriquement isolante disposée entre chacun desdits deux dissipateurs thermiques (13) et ledit module press-pack afin d'isoler électriquement ledit module press-pack (11) desdits deux dissipateurs thermiques (13).

10. Module de puissance à semi-conducteurs selon l'une quelconque des revendications précédentes, dans lequel chacun desdits deux dissipateurs thermiques (13) comprend au moins un canal de fluide (17).

11. Procédé pour assembler un module de puissance à semi-conducteur selon l'une quelconque des revendications 1 à 9 comprenant :
fournir (501) la sous-structure de module (10) d'un module de puissance à semi-conducteur selon l'une quelconque des revendications 1 à 9 ;
fournir (502) une première structure de serrage (6) comprenant un premier corps de serrage (7) et un deuxième corps de serrage (8) ;
serrer (503) ladite sous-structure de module entre ledit premier corps de serrage et ledit deuxième corps de serrage afin de presser la première barre omnibus (2) et la deuxième barre omnibus (3) l'une vers l'autre le long d'un premier axe (101) avec une première force de serrage, formant ainsi un module press-pack (11) ;
serrer (504) ledit module press-pack (11) entre deux dissipateurs thermiques le long d'un deuxième axe (102) perpendiculaire audit premier axe (101) avec une deuxième force de serrage.

12. Procédé selon la revendication 11, dans lequel ledit serrage (503) de ladite sous-structure de module entre ledit premier corps de serrage et ledit deuxième corps de serrage est effectué à une température dans la plage de ±20 K à partir de la température de fonctionnement moyenne cible de ladite ou desdites puces semi-conductrices.

13. Procédé selon la revendication 11 ou 12, dans lequel ladite première force de serrage résulte en une pression de surface appliquée sur chaque puce semi-conductrice de ladite au moins une puce semi-conductrice (5) dans la plage de 5 MPa à 60 MPa, de préférence dans la plage de 15 MPa à 45 MPa et le plus préférablement dans la plage de 20 MPa à 30 MPa.

14. Procédé selon l'une quelconque des revendications 11 à 13, dans lequel ladite deuxième force de serrage résulte en une pression de surface appliquée sur ledit module press-pack dans la plage de 10 MPa à 100 MPa, de préférence dans la plage de 15 MPa à 60 MPa et le plus préférablement dans la plage de 20 MPa à 30 MPa.
